# EUROPÄISCHE PATENTSCHRIFT

(11) **EP 2 059 933 B1**
(45) Veröffentlichungstag und Bekanntmachung des Hinweises auf die Patenterteilung: **15.09.2010**
(21) Anmeldenummer: 07787753.8
(22) Anmeldetag: 20.07.2007
(51) Int. Cl.: H01C 7/12, H01H 37/76

(54) **ÜBERSPANNUNGSABLEITER MIT EINEM GEHÄUSE UND MIT MINDESTENS EINEM ABLEITELEMENT**
SURGE ARRESTER HAVING A HOUSING AND HAVING AT LEAST ONE ARRESTING ELEMENT
PARAFOUDRE COMPRENANT UN BOÎTIER ET AU MOINS UN ÉLÉMENT DE DÉRIVATION

(30) Priorität: 07.09.2006 DE 102006042029; 09.11.2006 DE 102006052955
(43) Veröffentlichungstag der Anmeldung: 20.05.2009
(73) Patentinhaber: DEHN + SÖHNE GMBH + CO KG, 92318 Neumarkt/Opf (DE)
(72) Erfinder: EHRHARDT, Arnd, 92318, Neumarkt (DE); SCHREITER, Stefanie, 92318 Neumarkt (DE); ZÄUNER, Edmund, 92334 Berching/Pollanten (DE); KÖNIG, Raimund, 92369 Sengenthal (DE); GAECK, Florian, 92342 Freystadt (DE); HOHENWALDT, Wilhelm, 92318 Neumarkt (DE)
(74) Vertreter: Meissner, Bolte & Partner
(86) Internationale Anmeldenummer: PCT/EP2007/057498
(87) Internationale Veröffentlichungsnummer: WO 2008/028724

(56) Entgegenhaltungen:
- DE-A1- 3 734 214
- DE-U1- 9 012 881
- DE-U1- 9 305 796

## Beschreibung

Die Erfindung betrifft einen Überspannungsableiter mit einem Gehäuse und mindestens einem Ableitelement, beispielsweise einem Varistor, sowie einer Abtrennvorrichtung, um das oder die Ableitelemente vom Netz zu trennen, wobei die Abtrennvorrichtung eine Lötstelle umfasst, welche in den elektrischen Anschlusspfad innerhalb des Ableiters eingebunden ist, wobei über die Lötstelle ein beweglicher Leiterabschnitt oder eine bewegliche leitende Brücke mit dem Ableitelement einerseits und der Leiterabschnitt oder die Brücke andererseits mit einem ersten elektrischen Außenanschluss des Ableiters verbunden ist, sowie umfassend ein Vorspannkraft erzeugendes Mittel, beispielsweise Feder, wobei der diesbezügliche Kraftvektor auf den Leiterabschnitt oder die Brücke in Abtrennrichtung wirkt, gemäß Oberbegriff des Patentanspruchs 1.

Abtrennvorrichtungen auch mit Kurzschlussfunktion, wobei im aufgetrennten bzw. ausgelösten Schaltzustand der Abtrennvorrichtung der Strompfad über das defekte Ableiterelement sich im Kurzschluss befindet derart, dass der Strom vom Ableitelement auf einen geschalteten Bypass kommutiert, sind bekannt.
Der so geschaltete niederohmige Kurzschlusspfad kann z.B. dazu genutzt werden, ein vorgeschaltetes Schaltelement, welches auf den Kurzschlussstrom des betreffenden Netzes eingestellt ist, zu betätigen, oder aber einen definierten Dauerkurzschluss zu erzeugen, der bei bestimmten Anwendungen als so genannter Fail-Safe-Zustand definiert ist.

Zu diesem Stand der Technik soll beispielsweise auf die EP 0 860 927 A1 hingewiesen werden. In dieser Druckschrift ist eine sehr aufwendige elektromechanische Einrichtung beschrieben, die den Strom über einen Varistor überwacht und welche nach Überschreiten eines vorgegebenen Grenzwerts den Kurzschluss im Bypass zum Varistorpfad über elektromechanische Kontakte schaltet.

Gemäß der DE 37 34 214 C2 gehört eine thermisch auslösbare Abtrennvorrichtung zum Stand der Technik, deren schaltendes Element einen Wechselkontakt darstellt. Der Wechselkontakt schließt den Varistorkreis in bekannter Weise über eine Lotstelle. Wird das Schaltelement ausgelöst, wird ein weiterer Kontakt geschlossen, der entweder als interne oder externe Defektanzeige oder eben über eine entsprechende externe Verbindung als Kurzschluss verschaltet werden kann.

Zum Stand der Technik gehört die Anordnung zur Ableitung von Überspannungen, wobei mehrere überspannungsbegrenzende Element, wie z.B. Varistoren oder Dioden, und z.B. durch Überhitzung oder Feststellung des Leckstroms auslösende Abschaltmittel vorgesehen sind, gemäß DE 41 24 321 C2. Um die Sicherheit einer derartigen Anordnung zu verbessern, insbesondere redundant auszubilden, ist dort vorgesehen, dass zumindest zwei überspannungsbegrenzende Elemente angeordnet werden, von denen jedes Element für sich ausreichend dimensioniert ist, um an der betreffenden Einsatzstelle den Überspannungsschutz zu gewährleisten. Eine thermische Abschaltung im Sinne einer Thermosicherung überwacht den Leckstrom der überspannungsbegrenzenden Elemente, so dass z.B. ein erstes Element bei Überhitzung abgeschaltet und ein zweites Element zugeschaltet werden kann.

Eine zusätzliche Sicherung für den Fall, dass auch der nach Ausfall eines ersten Varistors zugeschaltete redundante Varistor ausfällt, besteht gemäß DE 41 24 321 C2 darin, den redundanten Varistor entweder durch Öffnen eines Schalters im Querstrompfad oder aber auch durch Öffnen des Schalters im Längsstrompfad von der Spannung zu trennen. Hierdurch wird gleichzeitig das zu schützende System vom Netz getrennt und vor schädlichen Überspannungen geschützt.
Alternativ soll es auch möglich sein, durch Kurzschließens eines zusätzlichen Schalters den Querstrompfad zu überbrücken, so dass letztendlich das geschützte System kurzgeschlossen ist. Das Öffnen dieses notwendigen Schalters kann über eine gemeinsame Betätigung synchron erfolgen. Falls ein Abschalten und/oder Kurzschließen des zu schützenden Systems nicht erwünscht ist, kann die Funktion des vorerwähnten Schalters durch Einsetzen einer Überbrückung oder Entfernen eines solchen Mittels aufgehoben werden. Grundsätzlich ist jedoch die Anordnung von zusätzlichen Schaltern für den Kurzschluss entweder im Längs- oder Querstrompfad erforderlich, was den Aufwand beim ohnehin begrenzten Bauraum eines in einem Gehäuse befindlichen Überspannungsableiters weiter einschränkt.

Insbesondere bei Photovoltaik-Anlagen ist aufgrund der Charakteristik der speisenden Quelle der dortige Betriebsstrom annähernd gleich dem Kurzschlussstrom. Ein klassisches Abtrennen bei Erwärmung eines Varistors und seiner Abtrennvorrichtung ist bei derartigen Gleichspannungsapplikationen nicht zielführend, da die Systemspannung von Photovoltaik-Anlagen bis zu 1000 V beträgt und die Unterbrechung von 1000 V-Gleichstromkreisen nur mit einem erheblichen konstruktiven oder apparativen Aufwand überhaupt realisierbar ist.

Aus dem Vorgenannten ist es daher Aufgabe der Erfindung, einen weiterentwickelten Überspannungsableiter mit einem Gehäuse und mindestens einem Ableitelement, beispielsweise einem Varistor, sowie einer Abtrennvorrichtung anzugeben, der ohne externe Verschaltung in der Lage ist, einen Kurzschlussstrom sicher zu führen, so dass sich neue Anwendungsbereiche für in diesem Sinne aufrüstbare Ableiter ergeben.

Die Lösung der Aufgabe der Erfindung erfolgt durch einen Überspannungsableiter gemäß Merkmalskombination des Patentanspruchs 1, wobei die Unteransprüche zweckmäßige Ausgestaltungen und Weiterbildungen darstellen.

Es werden an sich bekannte Abtrennvorrichtungen für Überspannungsableiter mit einer zusätzlichen Verbindung ausgerüstet, die die vorhandene Abtrennfunktion um eine Kurzschlussfunktion erweitert.

In der nachstehenden Beschreibung wird bezüglich der Abtrennvorrichtung davon ausgegangen, dass diese eine Lötstelle mit einem bei entsprechender Ansprechtemperatur schmelzenden Lot umfasst. Selbstverständlich kann die Abtrennvorrichtung auch durch andere schmelzende Materialien realisiert werden, die selbst keine leitenden Eigenschaften aufweisen, und zwar dann, wenn die elektrische Verbindung zum Anschlusspfad über ein Brückenteil vorgenommen wird, dessen mechanische Lage mit Hilfe des schmelzenden Materials gesichert ist.

Weiterhin ist im Bewegungsweg des federvorgespannten Leiters oder der federvorgespannten Brücke mindestens ein leitfähiges Element angeordnet, dessen erstes Ende bei ausgelöster Abtrennvorrichtung mit dem Leiterabschnitt oder der Brücke in Kontakt gelangt.

Das zweite Ende des leitfähigen Elements ist mit einem zweiten elektrischen Außenanschluss in Verbindung stehend. Erfindungsgemäß sind Mittel zum Schützen der Kontaktstelle zwischen Leiterabschnitt oder Brücke und dem leitfähigen Element vor wegspratzenden Lotresten vorgesehen.

In einer bevorzugten Ausgestaltung ist das leitfähige Element als brückenartiger Bügel ausgeführt, dessen zweites Ende mit dem elektrischen Außenanschluss beim Anziehen einer hierfür vorgesehenen Klemme verbindbar ist. Auf diesem Wege vereinfacht sich die Montage, da der brückenartige Bügel nicht separat kontaktiert werden muss.

Erfindungsgemäß weist das erste Ende des leitfähigen Elements eine Plattenform mit einer Aussparung. Die Platte kann eine im wesentlichen parallele Orientierung zum Leiterabschnitt oder zu der Brücke, und zwar bezogen auf den Abtrennfall, besitzen. Durch diese parallele Orientierung soll ein möglichst großflächiges, niederohmiges Kontaktieren und Anliegen realisiert werden.

Erfindungsgemäß ist die Aussparung derart angeordnet, dass die Lötstelle nicht in Kontakt mit dem plattenförmigen Ende gelangen kann und wegspratzendes Lot durch den mittels Aussparung gegebenen Freiraum treten kann.

Die Platte kann an ihrer zum zweiten Ende gerichteten Unterseite eine Aussparung oder einen Rücksprung zur Aufnahme von wegspratzendem Lot bzw. schmelzendem Material auf weisen. Auf diesem Wege wird wirksam verhindert, dass sich Lot auf der Platte niederschlägt und dort erhabene Stellen bildet, mit der Folge eines unerwünschten Übergangswiderstands. Auch ist die Aussparung in der Lage, gegebenenfalls erodiertes Material des Leiterabschnitts oder der Brücke aufzunehmen.

Es ist das leitfähige Element auch nachträglich in den Ableiter einsetzbar, um neben einer Abtrenn- auch eine Kurzschluss-Fail-Safe-Funktion zu realisieren.

Der bevorzugt vorgesehene brückenartige Bügel als leitfähiges Element weist Mittel zum Befestigen am oder im Ableitergehäuse auf.

Diese Mittel können z.B. eine Nut oder eine Aussparung im Bügel sowie eine hierzu komplementäre Nase oder eine Gegennut im Gehäuse zum Herstellen eines Formschlusses umfassen. Fachgemäße Abwandlungen eines solches Befestigungsmittels gehören selbstverständlich zu den denkbaren Alternativen.

Zum wahlweisen Aktivieren des leitfähigen Elements im Sinne eines im Abtrennfall wirkenden Kurzschließers ist ein Isolierplättchen zwischen dem leitfähigen Element und dem Leiterabschnitt oder der Brücke anordenbar. Alternativ kann das leitfähige Element mindestens auf seinem ersten Ende mit einem lösbaren Isolierüberzug, z.B. in Form eines Isolierschlauches versehen sein. Ebenso wie das Isolierplättchen kann auch der Isolierüberzug über eine geeignete Öffnung im Gehäuse entfernt werden, um die Zusatzfunktion "Kurzschluss" freizugeben.

Zum wahlweisen Aktivieren des leitfähigen Elements kann bei einer Ausführungsform der Erfindung der relative Abstand zwischen dem leitfähigen Element und dem Leiterabschnitt oder der Brücke eingestellt werden. Dabei gilt es in einer ersten Position zu bewerkstelligen, dass der Leiterabschnitt oder die Brücke im Abtrennfall in ausreichenden Kontakt mit dem leitfähigen Element gelangt. Andererseits kann durch eine Wegbegrenzung bezüglich des Leiterabschnitts oder der Brücke verhindert werden, dass das leitfähige Element berührt wird. Denkbar ist bei dieser Ausführungsform die Anordnung eines Weg- oder Hub begrenzenden, verstellbaren Exzenters.

Zum wahlweisen Aktivieren des leitfähigen Elements im Sinne eines im Abtrennfall wirkenden Kurzschließers kann bei einer ergänzenden Ausführungsform in den Bewegungsweg des Leiterabschnitts oder der Brücke ein begrenzendes Element z.B. in Form eines Stiftes, Bolzens oder dergleichen Anschlag eingesetzt werden.

Wie bereits dargelegt, ist vorgesehen, das Isolierplättchen oder den Stift bzw. Bolzen von außen durch das Gehäuse hindurch zugänglich zu gestalten, insbesondere um diese Mittel nachträglich entfernen zu können.

Die jeweils aktivierte Kurzschlussfunktion ist über eine Anzeige signalisierbar. Dabei kann auch vorgesehen sein, den Zugang zum Entfernen des Isolierplättchens, des Stiftes oder des Bolzens zu verplomben. Eine hier beispielsweise denkbare pfropfenartige Plombe nimmt beim Entfernen das Isolierplättchen oder den Stift oder den Bolzen mit. Ein derart plombenfreier Überspannungsableiter zeigt die vorgesehene zusätzliche Kurzschlussfunktion an.

Die Erfindung soll nachstehend anhand eines Ausführungsbeispiels sowie unter Zuhilfenahme von Figuren näher erläutert werden.

Hierbei zeigen:
- Fig. 1: ein Prinzipschaltbild eines Ableiters mit Varistoren und kombinierten Abtrenn- und Kurzschließeigenschaften;
- Fig. 2: eine schematische Darstellung einer Abtrennvorrichtung mit Schaltfunktion im Zustand nicht ausgelöst;
- Fig. 3: eine Darstellung ähnlich derjenigen nach Fig. 2, jedoch im Zustand ausgelöst und Kurzschluss;
- Fig. 4: eine Schalteinrichtung mit entfernbarer Isolierplatte;
- Fig. 5a: und 5b eine Schalteinrichtung, wobei die Kurzschlussfunktion durch exzentergesteuerte Bewegung des leitfähigen Elements einstellbar ist;
- Fig. 6: ein erfindungsgemäßer Überspannungsableiter mit einem Gehäuse und einem Varistor-Ableitelement sowie thermischer Abtrennvorrichtung, wobei ein Abtrennbock eine mechanische Bewegung auf die thermische Abtrennvorrichtung überträgt und im Abtrennfall ein Kurzschließen über einen brückenartigen Bügel als leitfähiges Element erfolgt;
- Fig. 6b: eine Darstellung ähnlich derjenigen nach Figur 6 jedoch im abgetrennten Zustand und ausgelöstem Kurzschluss sowie

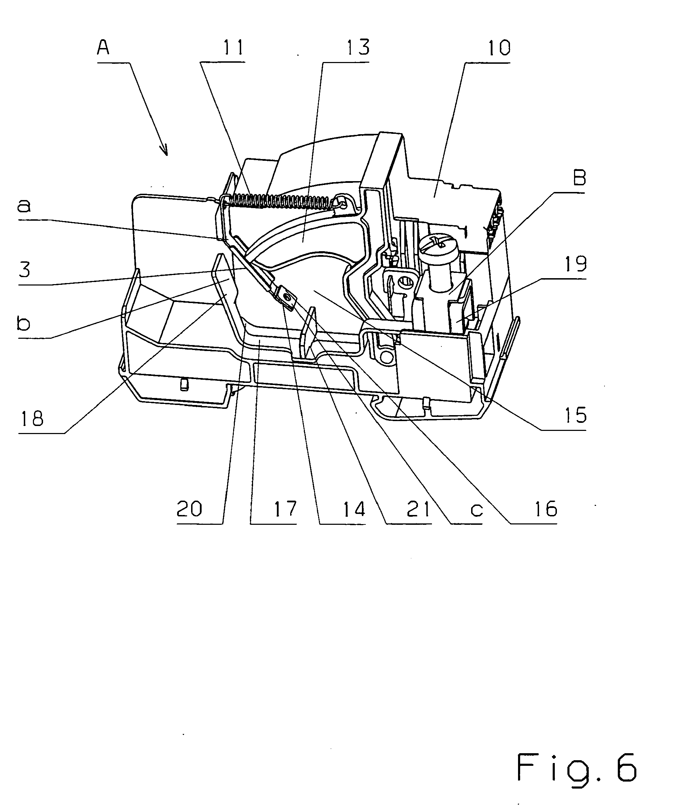

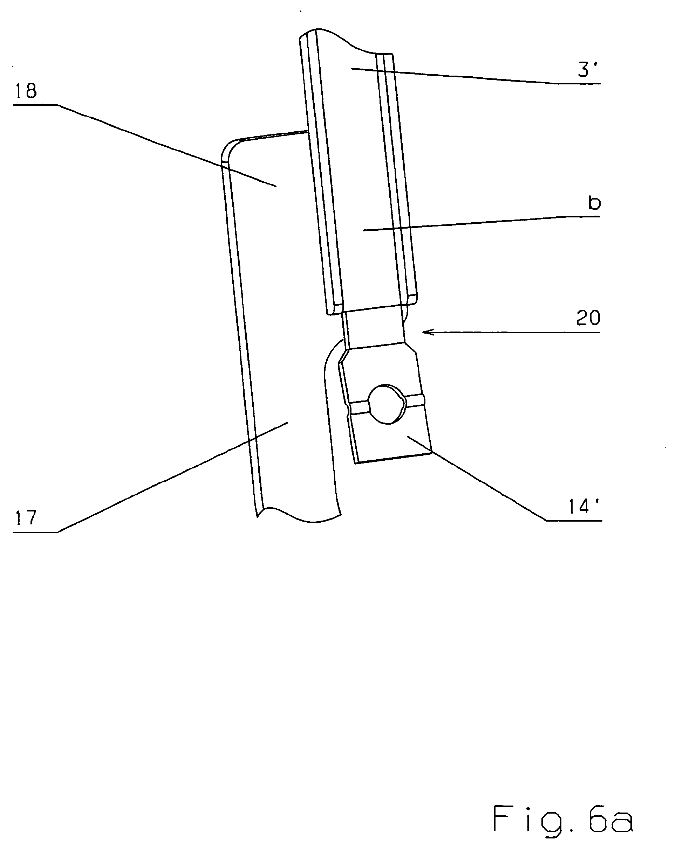

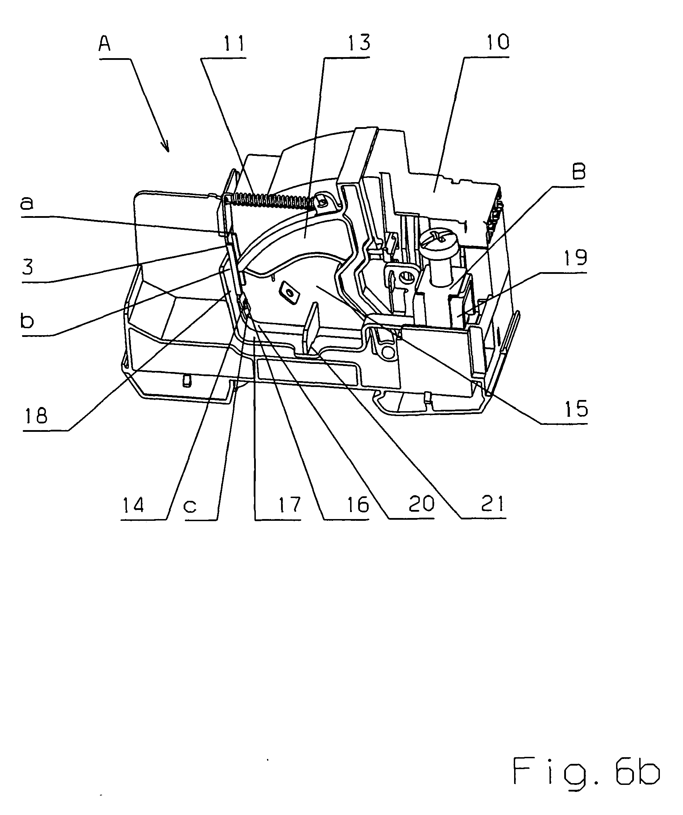

- Fig. 6a: eine Detaildarstellung des plattenförmigen Endes vom brückenartigen Bügel aus Fig. 6b mit erkennbarer Aussparung in Kurzschlussposition bezüglich der Schaltzunge.

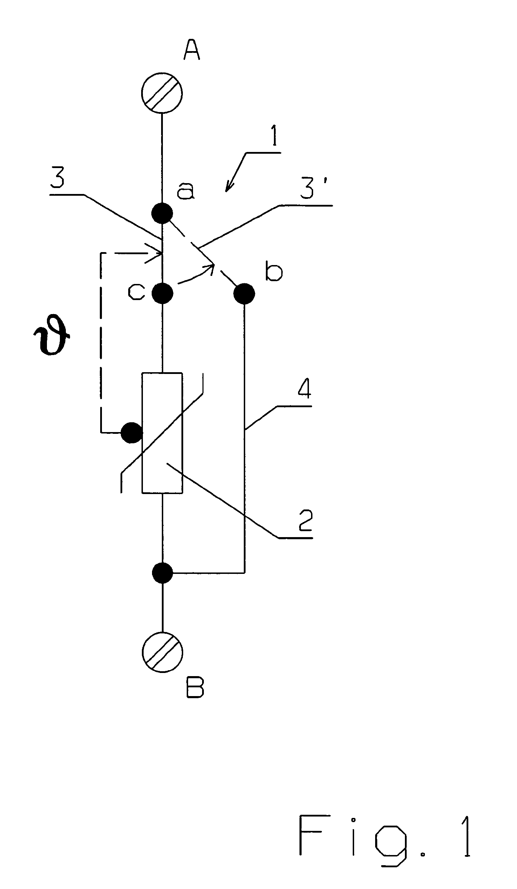

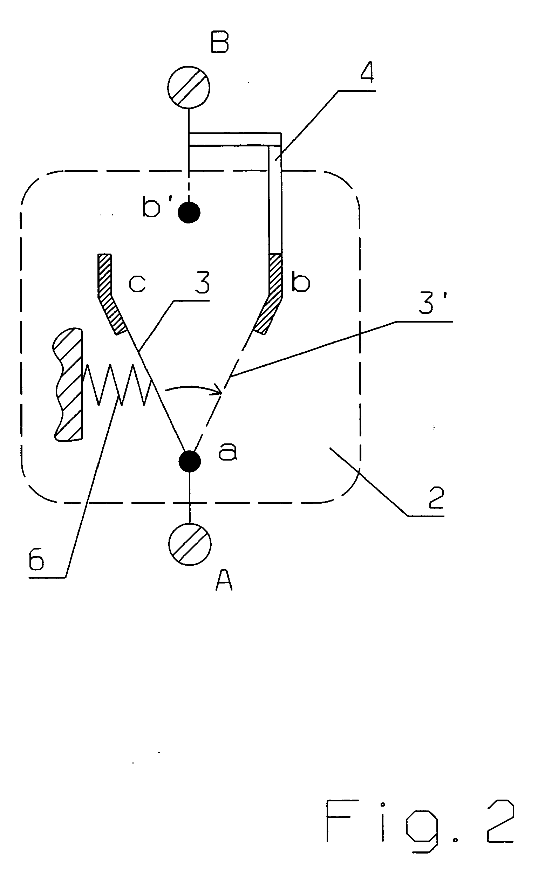

Gemäß der Darstellung nach Fig. 1 wird zwischen den äußeren Anschlüssen A und B ein Varistor 2 geschaltet. Dieser Varistor 2 ist über eine Abtrennvorrichtung (Schaltzunge) 3, die thermisch auslösbar ist, abtrennbar. Zwischen den Punkten a und c besteht üblicherweise über einen Leiterabschnitt oder eine Brücke eine elektrische Verbindung, und zwar im nicht ausgelösten Zustand. Im Zustand 3' ist die Abtrennvorrichtung 1 ausgelöst und es wurde eine Verbindung auf dem Weg a zu b mit Hilfe eines Kurzschlussbügels 4 hergestellt, welcher den Varistor 2 überbrückt. Der betätigte bzw. ausgelöste Kurzschlusszustand ist gemäß Figur zwischen den Punkten a und b gestrichelt dargestellt. Unter Hinweis auf die Fig. 2 bis 5 wird die Schaltbewegung nach dem Auslöten eines Lotmittels unter dem Einfluss einer Druckfeder 6 (Bezugszeichen 11 gemäß Fig. 6 und 6 b) ausgeführt.

Die Fig. 2 zeigt schematisch eine Schalteinrichtung 1 mit Abtrenn- und Kurzschlussfunktion im nicht betätigten bzw. nicht ausgelösten Zustand.
Der betätigte, d.h. ausgelöste Kurzschlusszustand ist gemäß Fig. 2 in der Darstellung zwischen den Punkten a und b gestrichelt dargestellt. Wie erwähnt, erfolgt die Schaltbewegung nach dem Auslötvorgang unter dem Einfluss der Kraft der Feder 6. Die Zunge 3, welche den Leiterabschnitt bildet, wird also gleichzeitig zur Realisierung des gewünschten Kurzschlusses zwischen den Anschlusspunkten A und B genutzt, indem diese in Anschlag mit dem leitfähigen Element bzw. dem Kurzschlussbügel 4 gelangt.

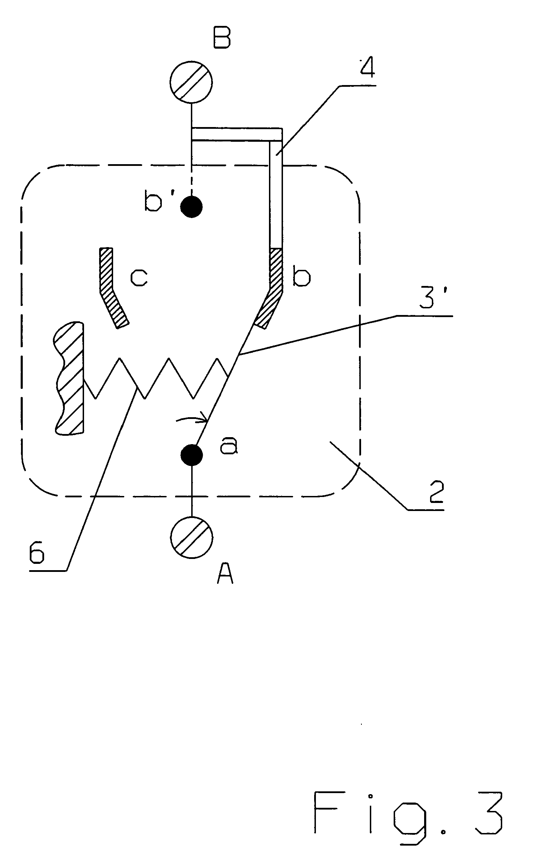

Mit Hilfe der Fig. 3 wird der betätigte bzw. ausgelöste Zustand, d.h. der gewünschte Kurzschluss zwischen den Punkten A und B, deutlich, und zwar infolge der Bewegung der Schaltzunge, die sich jetzt in der Kurzschlusslage 3' befindet.

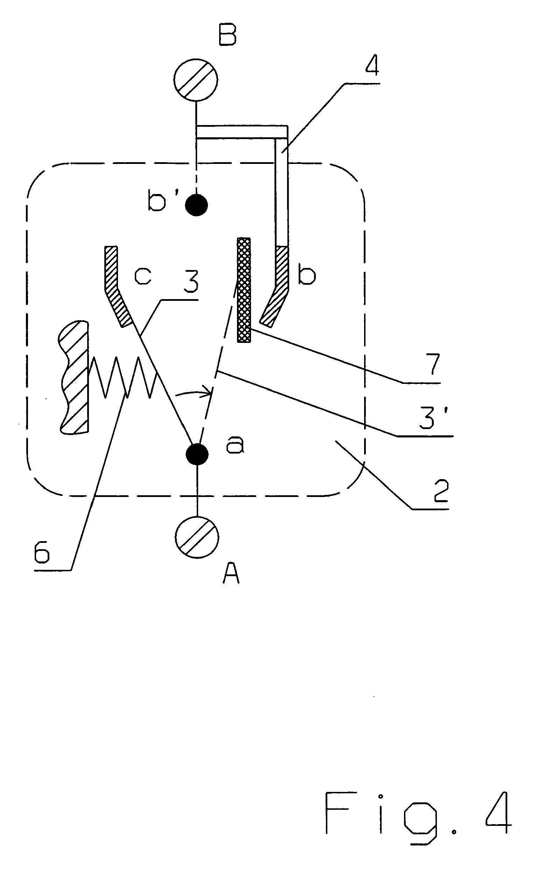

Bei dem Beispiel gemäß der Fig. 4 ist ein Isolierplättchen 7 so angeordnet, dass die Schaltzunge 3 bzw. 3' nicht in Anlage zum Kurzschlussbügel 4 gelangen kann. Dies bedeutet, dass der Bewegungsweg der Schaltzunge 3, 3' durch die Isolierplatte 7 begrenzt wird. Anstelle einer Isolierplatte 7 kann im Sinne der Erfindung auch ein Stift oder ein Bolzen Verwendung finden oder es besteht die Möglichkeit, mindestens das gestrichelt dargestellte Ende des Kurzschlussbügels 4 mit einem entfernbaren Isolierschlauch zu überziehen.

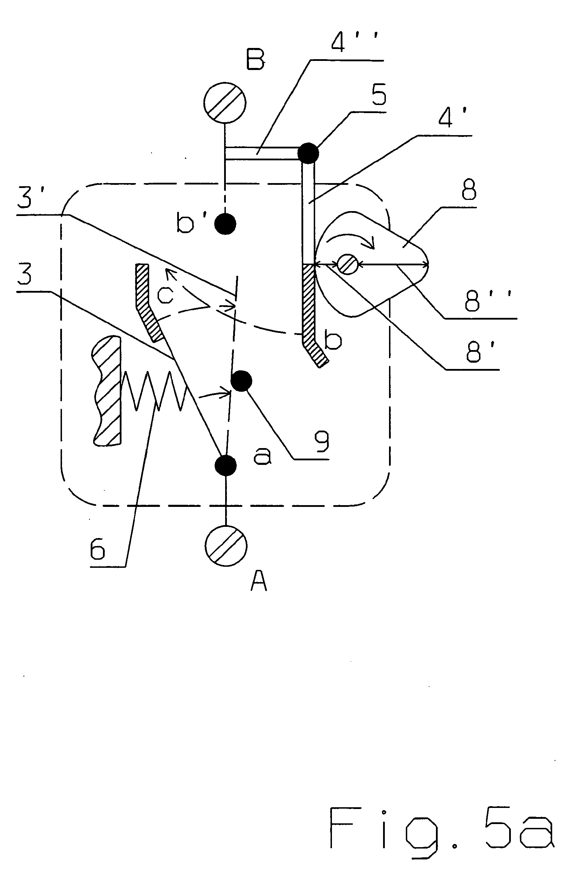

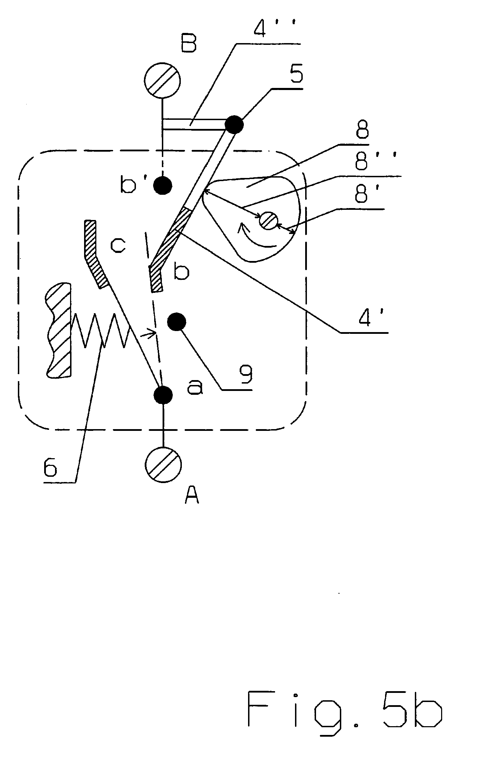

Gemäß den Darstellungen nach den Fig. 5a und 5b ist bei der Schalteinrichtung 1 deren Kurzschlussfunktion über eine manuelle Betätigung eines Mittels, insbesondere eines Exzenters 8 zu- oder abschaltbar.

Mit Hilfe des Exzenters 8, der verschiedene Betätigungsstrecken 8', 8" ermöglicht, kann ein beweglicher Teil 4' des Kurzschlussbügels bezüglich des starren Bügelteils 4" verändert werden, so dass, wie in der Fig. 5b angedeutet, ein Inkontaktkommen mit der Schaltzunge 3 realisierbar ist, was in der Position des beweglichen Teils des Kurzschlussbügels 4' nach Fig. 5a nicht möglich ist. Zum Zweck der Bewegungsbegrenzung der Schaltzunge ist bei dieser Ausführungsform noch ein Anschlag 9 vorgesehen.

Der Exzenter 8 kann über eine Öffnung im gestrichelt dargestellten Gehäuse leicht in seine verschiedenen Positionen gemäß den Darstellungen nach Fig. 5a und 5b verstellt werden, wobei durch das erkennbare freie Betätigungsende des Exzenters 8 auch deutlich wird, welcher jeweilige Zustand (Kurzschluss oder nicht) vorliegt.

In der Schalterstellung Abtrennen nach Fig. 5a befindet sich somit ein über den Drehpunkt 5 gelagerter Kurzschlussbügel 4' außerhalb des Aktionsradius und des Wirkungsbereichs der Schaltzunge 3, so dass ein Kontakt über den Weg a/b verhindert ist.

In der Position "Kurzschließen" hingegen wird durch die über die exzenterförmige Scheibe 8 hergestellte Verschiebung des beweglichen Kurzschlussbügels 4' in den Aktionsbereich der Schaltzunge 3 hinein eine Verbindung über den Weg a/b ermöglicht.

Bei dem Ausführungsbeispiel nach Fig. 6 ist ein Überspannungsableiter mit zusätzlicher Kurzschlussfunktion in ein Gehäuse 10 integriert. Mit Hilfe eines verschwenkbar gelagerten Abtrennbocks 13 und der Zugfeder 11 wirkt eine Vorspannung auf die Schaltzunge 3, die mit Hilfe eines Lotes 14 mit einem durch die Gehäusetrennwand 15 geführten Anschluss 16 eines (nicht gezeigten) Varistors verbunden ist.

Das leitfähige Element ist gemäß der Ausführungsform nach Fig. 6 als brückenartiger Bügel 17 ausgebildet. Dieser brückenartige Bügel 17 weist ein erstes Ende in Plattenform 18 auf. Ein zweites Ende des brückenartigen Bügels 17 steht mit einem elektrischen Außenanschluss beim Anziehen einer hierfür vorgesehenen Klemme 19 in Verbindung.

Das plattenförmige Ende 18 des brückenartigen Bügels 17 weist an seiner zum zweiten Ende gerichteten Unterseite eine Aussparung 20 zur Aufnahme von im Abtrennfall möglicherweise weg spratzendem Lot vom Lotpunkt 14 auf.

Der brückenartige Bügel 17 ist über Mittel zum Befestigen 21 am oder im Ableitergehäuse 10 fixierbar. Der Abstand zwischen dem plattenförmigen Ende 18 des leitfähigen Elements und dem Leiterabschnitt bzw. der Schaltzunge 3 kann durch Abwinkeln oder Biegen des plattenförmigen Endes 18 eingestellt oder verändert werden. Maßgeblich ist die Winkellage des plattenförmigen Endes 18 bezogen auf die Position der Schaltzunge 3. Auf jeden Fall ist hier sicherzustellen, dass für den gewünschten sicheren Kurzschluss die Schaltzunge 3 großflächig und eben mit dem plattenförmigen Ende 18 in Kontakt gelangt.

Wird gemäß der Darstellung nach Fig. 6 die Schaltzunge über den Lotpunkt 14 an der Position c ausgelötet, erfolgt eine Drehbewegung des Abtrennbocks 13 und damit eine Schaltbewegung der Schaltzunge 3 bis in die Endstellung gemäß Position b, welche der Kurzschlussposition entspricht.

Aus der Darstellung nach Fig. 6 wird ersichtlich, dass der weiterentwickelte Überspannungsableiter mit Kurzschlussfunktion ohne weiteres in einem Standardgehäuse zur Hutschienenmontage untergebracht werden kann, wobei der brückenartige Bügel 17 nach Abnahme des nicht gezeigten Gehäusedeckels leicht zugänglich ist. Es kann hierdurch montageseitig ein Überspannungsableiter ohne, aber auch mit Kurzschlussfunktion mit wenig Aufwand bereitgestellt werden, wobei durch nachträgliches Einsetzen des brückenartigen Bügels 17 auch eine spätere Kurzschlussfunktion realisierbar ist.

Figur 6b zeigt eine Darstellung der erfindungsgemäßen Abtrennvorrichtung in einem realisierten Gerät und zwar im ausgelösten Zustand (Schalterstellung ausgelöst b).

Die Aussparung 20 im Bereich des plattenförmigen Endes 18 vom brückenartigen Bügel 17 liegt derart, dass der Lotpunkt 14 der Schaltzunge 3 nicht in Kontakt mit dem brückenartigen Bügel 17 gelangt. Möglicherweise hier anhaftendes oder wegspratzendes Lot kann durch den mittels der Aussparung 20 gegebenen Freiraum treten und führt nicht zu einem möglicherweise überhöhten Übergangswiderstand.

Es ist also der mit der Lotpaste versehenen Lotpunkt 14 bzw. 14' (siehe Figur 6a) nicht an der eigentlichen großflächigen Kontaktgabe beteiligt. Nur der Teil b der Schaltzunge 3' liegt auf der Oberfläche des plattenförmigen Endes 18 des brückenartigen Bügels 17 an.

## Patentansprüche

1. Überspannungsableiter mit einem Gehäuse (10) und mindestens einem Ableitelement, beispielsweise einem Varistor, sowie eine Abtrennvorrichtung, um das oder die Ableitelemente vom Netz zu trennen, wobei die Abtrennvorrichtung eine Lötstelle (14) umfasst, welche in den elektrischen Anschlusspfad (A; B) innerhalb des Ableiters eingebunden ist, wobei über die Lötstelle (14) ein beweglicher Leiterabschnitt oder eine bewegliche leitende Brücke (3) mit dem Ableitelement einerseits und der Leiterabschnitt oder die Brücke andererseits mit einem ersten elektrischen Außenanschluss des Ableiters verbunden ist, sowie umfassend ein Vorspannkraft erzeugendes Mittel, beispielsweise eine Feder (6; 11), wobei der diesbezügliche Kraftvektor auf den Leiterabschnitt oder die Brücke (3) in Abtrennrichtung wirkt, weiterhin im Bewegungsweg des Leiterabschnitts oder der Brücke (3) ein leitfähiges Element (4; 17) angeordnet ist, dessen erstes Ende bei ausgelöster Abtrennvorrichtung mit dem Leiterabschnitt oder der Brücke (3) in Kontakt gelangt, wobei dessen zweites Ende mit einem zweiten elektrischen Außenanschluss in Verbindung steht,
**dadurch gekennzeichnet, dass**
Mittel zum Schützen der Kontaktstelle zwischen Leiterabschnitt oder Brücke (3) und dem leitfähigen Element (4; 17) vor wegspratzenden Lotresten vorgesehen sind, wobei hierfür das erste Ende des leitfähigen Elements (17) eine Plattenform (18) mit einer Aussparung (20) aufweist, die derart angeordnet ist, dass die Lötstelle (14) nicht in Kontakt mit dem plattenförmigen Ende (18) gelangen kann und wegspratzendes Lot durch den mittels der Aussparung (20) gegebenen Freiraum treten kann, sowie der Kraftvektor mittelbar oder unmittelbar über einen beweglichen Trennbock (13) auf den Leiterabschnitt oder die Brücke (3) wirkt.

2. Überspannungsableiter nach Anspruch 1,
**dadurch gekennzeichnet, dass**
das plattenförmige Ende (18) eine parallele Orientierung zum Leiterabschnitt oder der Brücke (3) bezogen auf den Abtrennfall besitzt.

3. Überspannungsableiter nach Anspruch 1 oder 2,
**dadurch gekennzeichnet, dass**
die Platte oder das plattenförmige Ende (18) an ihrer zum zweiten Ende des als brückenartiger Bügel (17) ausgebildeten leitfähigen Elements gerichteten Unterseite die Aussparung (20) zur Aufnahme von wegspratzendem Lot aufweist.

4. Überspannungsableiter nach Anspruch 3,
**dadurch gekennzeichnet, dass**
der brückenartige Bügel (17) Mittel zum Befestigen (21) am oder im Ableitergehäuse (10) aufweist, die eine Nut oder Aussparung im Bügel (17) sowie eine hierzu komplementäre Nase oder Gegennut im Gehäuse (10) zum Herstellen eines Formschlusses umfassen.

5. Überspannungsableiter nach einem der vorangegangenen Ansprüche,
**dadurch gekennzeichnet, dass**
der Leiterabschnitt oder die Brücke (3) aus einem nicht flexiblen Material besteht.

6. Überspannungsableiter nach Anspruch 2,
**dadurch gekennzeichnet, dass**
der Abstand zwischen der Platte bzw. dem plattenförmigen Ende (18) des leitfähigen Elements (4; 17) und dem Leiterabschnitt oder der Brücke (3), bevorzugt durch Abwinkeln oder Biegen des ersten Endes, veränder- oder einstellbar ist.

7. Verwendung eines Überspannungsableiters nach einem der vorangegangenen Ansprüche
in Gleichspannungsanlagen mit hohen Systemspannungen und Betriebsströmen auf Kurzschlussstromniveau, insbesondere Photovoltaik-Anlagen.

## Claims

1. Surge arrester, comprising a housing (10) and at least one arrester element, for example a varistor, as well as a disconnecting device to disconnect the arrester element(s) from the power supply system, wherein the disconnecting device includes a soldering point (14) which is integrated in the electrical connection path (A; B) within the arrester, wherein a movable conductor section or a movable conductive bridge (3) is connected via the soldering point (14) to the arrester element, on the one hand, and the conductor section or the bridge is connected to a first electrical external connection of the arrester, on the other hand, and comprising a means to produce a prestressing force, for example a spring (6; 11), with the relevant force vector acting onto the conductor section or the bridge (3) in the disconnecting direction, wherein further a conductive element is (4; 17) is arranged in the path of the movement of the conductor section or the bridge (3), the first end of which comes into contact with the conductor section or the bridge (3) if the disconnecting device is activated, wherein the second end thereof is connected to a second electrical external connection,
**characterized in that**
means are provided for protecting the contact point between the conductor section or bridge (3) and the conductive element (4; 17) against splashed out solder residues, for which purpose the first end of the conductive element (17) is plate-shaped (18) and comprises a recess (20) which is arranged in such a way that the soldering point (14) cannot come into contact with the plate-shaped end (18) and splashed out solder can pass through the free space provided by the recess (20) and the force vector acts indirectly or directly via a movable disconnecting component (13) onto the conductor section or the bridge (3).

2. Surge arrester according to claim 1,
**characterized in that**
the plate-shaped end (18) has a parallel orientation with respect to the conductor section or the bridge (3) relative to the case of disconnection.

3. Surge arrester according to claim 1 or 2,
**characterized in that**
the plate or the plate-shaped end (18) comprises the recess (20) for receiving splashed out solder on its lower side directed toward the second end of the conductive element formed as bridge-type link (17).

4. Surge arrester according to claim 3,
**characterized in that**
the bridge-type link (17) comprises means (21) for fixing it to or into the arrester housing (10), which comprise a groove or a recess in the link (17) as well as a nose or a counter-groove complementary thereto in the housing (10) so as to realize a positive joint.

5. Surge arrester according to one of the preceding claims,
**characterized in that**
the conductor section or the bridge (3) is made of a non-flexible material.

6. Surge arrester according to claim 2,
**characterized in that**
the distance between the plate or plate-shaped end (18) of the conductive element (4; 17) and the conductor section or the bridge (3) can be altered or adjusted preferably by offsetting or bending the first end.

7. Use of a surge arrester according to one of the preceding claims in direct voltage systems with high system voltages and operating currents on a short-circuit current level, especially for photovoltaic systems.

## Revendications

1. Dispositif dérivateur de surtensions comprenant un boîtier (10) et au moins un élément dérivateur, par exemple un varistor, ainsi qu'un dispositif de coupure, afin de séparer le ou les éléments dérivateurs depuis le réseau, dans lequel le dispositif de coupure comprend un emplacement de brasage (14), qui est intégré dans le trajet de raccordement électrique (A ; B) à l'intérieur du dispositif dérivateur, dans lequel un tronçon conducteur mobile ou un pont conducteur mobile (3) est relié via l'emplacement de brasage (14) avec l'élément dérivateur d'une part, et le tronçon conducteur ou le pont d'autre part est relié à un premier branchement électrique extérieur du dérivateur, et comprenant un organe qui engendre une force de précontrainte, par exemple un ressort (6 ; 11), tel que le vecteur de force se rapportant à celui-ci agit sur le tronçon conducteur ou sur le pont (3) en direction de coupure, et il est en outre prévu un élément conducteur (4 ; 17) agencé dans le trajet de déplacement du tronçon conducteur ou du pont (3), dont la première extrémité vient en contact avec le tronçon conducteur ou avec le pont (3) lorsque le dispositif de coupure est déclenché, et dont la seconde extrémité est connectée à un second raccordement électrique extérieur,
**caractérisé en ce que**
il est prévu des moyens pour protéger l'emplacement de contact entre le tronçon conducteur ou le pont (3) et l'élément conducteur (4 ; 17) vis-à-vis de résidus de brasage éclaboussés, et dans ce but la première extrémité de l'élément conducteur (17) présente une forme en plaque (18) avec une échancrure (20), laquelle est agencée de telle façon que l'emplacement de brasage (14) ne peut pas venir en contact avec l'extrémité en forme de plaque (18) et l'agent de brasage éclaboussé peut pénétrer à travers l'espace libre défini au moyen de l'échancrure (20), et le vecteur de force agit sur le tronçon conducteur ou sur le pont (3) soit directement soit indirectement via un bloc de coupure mobile (13).

2. Dispositif dérivateur de surtensions selon la revendication 1, **caractérisé en ce que** l'extrémité en forme de plaque (18) possède une orientation parallèle au tronçon conducteur ou au pont (3), par référence à la situation de coupure.

3. Dispositif dérivateur de surtensions selon la revendication 1 ou 2, **caractérisé en ce que** la plaque ou l'extrémité (18) en forme de plaque présente l'échancrure (20), pour la réception de l'agent de brasage éclaboussé, au niveau de sa face inférieure orientée vers la seconde extrémité de l'élément conducteur, réalisée sous forme d'une crosse (17) analogue à un pont.

4. Dispositif dérivateur de surtensions selon la revendication 3, **caractérisé en ce que** la crosse (17) analogue à un pont comprend des moyens pour la fixation (21) sur ou dans le boîtier (10) du dispositif dérivateur, ces moyens comprenant une gorge ou une échancrure dans la crosse (17) ainsi qu'un ergot ou une gorge antagoniste complémentaire à celle-ci dans le boîtier (10) pour établir une coopération dé formes.

5. Dispositif dérivateur de surtensions selon l'une des revendications précédentes,
**caractérisé en ce que** le tronçon conducteur ou le pont (3) est en un matériau non flexible.

6. Dispositif dérivateur de surtensions selon la revendication 2, **caractérisé en ce que** la distance entre la plaque, respectivement l'extrémité en forme de plaque (18) de l'élément conducteur (4 ; 17) et le tronçon conducteur ou le pont (3) est variable ou réglable, de préférence par coudage ou cintrage de la première extrémité.

7. Utilisation d'un dispositif dérivateur de surtensions selon l'une des revendications précédentes dans des installations à courant continu présentant des tensions systémiques ou des tensions de service au niveau de courants de court-circuit, en particulier des installations photovoltaïques.
